# EUROPEAN PATENT APPLICATION

(11) **EP 0 632 493 A1**
(43) Date of publication of application: **04.01.1995**
(21) Application number: 93830282.5
(22) Date of filing: 30.06.1993
(51) Int. Cl.: H01L 21/60, H01L 21/607, H01L 23/49

(54) **Semiconductor device with twice-bonded wire and method for manufacturing**

(71) Applicant: SGS-THOMSON MICROELECTRONICS S.r.l., I-20041 Agrate Brianza (Milano) (IT); CO.RI.M.ME. CONSORZIO PER LA RICERCA SULLA MICROELETTRONICA NEL MEZZOGIORNO, I-95121 Catania (IT)
(72) Inventor: Grasso, Antonio, I-95030 Gravina di Catania (CT) (IT); Pinto, Antonio, I-95128 Catania (IT)

(57) **Abstract**

The invention relates to semiconductor devices having improved quality and reliability features, wherein the wire leads which connect the semiconductor chip to the pins extend unbroken and are bonded twice on each pin to improve the bonding reiability.

The invention also concerns a method for manufacturing such a semiconductor device.

## Description

### Field of the Invention

This invention relates to semiconductor devices having improved quality and reliability features, and to a corresponding manufacturing method.

As is well known in the specific field of this invention, electric connections require to be established between a chip of a semiconductor device and corresponding pins provided on a supporting metal frame.

The semiconductor device may be of various kind, such as a transistor, an integrated circuit, etc..

The semiconductor chip is provided with predetermined contact pads to which external terminations of the semiconductor device are led.

On the other hand, the frame is formed with connection pins for mounting and connecting the semiconductor device, at the end of the manufacturing process, on a pre-printed electronic board.

Wires of a conductive material are connected between the pads on the chip and the inward ends of the pins.

This step of connecting the semiconductor chip to corresponding pins is a critical for a proper performance of the ultimate semiconductor device.

As a matter of fact, it should be considered that at this stage of the manufacturing process, the chip has already passed an electric test checking the proper performance of its circuitry.

Thus, unless the wire connections are absolutely faultless, the semiconductor may fail to operate, or reveal malfunctions and shall be rejected.

In particular, the device may fail to operate correctly during the electric testing thereof, as the result of a faulty bonding. But still worse and hence more undesirable is the risk of faulty operation of the semiconductor device, or that the device may fail to operate after some time in use, due to any faulty bonded connection.

It can be appreciated, therefore, that there exist aspects of the device quality and reliability which do depend on successful bonding of the connecting wires. Also evident is the importance of such aspects to the manufacturers of semiconductor circuits.

### Background Art

In order to provide bonded connections of good quality and reliability, stitch wire bonding equipment has been employed. Each equipment carries, on its end portion, an automatically operated bonding head for bonding the ends of a wire lead to the chip and to the post lead portions of the metal frame contact pins, respectively.

While substantially achieving its objective, such equipment isn't yet ensuring a sufficient degree of accuracy and reliability to avoid all the problems with which bonded wire connections have been beset.

It should be further mentioned that bonded connections may occasionally turn out below standard for causes residing in the bonding area itself, such as the local presence of oxidations or impurities.

Furthermore, a current trend in the art leaves increasingly less area available for bonding the wires, especially at the chip contact pads, which adds to the problems encountered.

It is a primary object of this invention to provide a semiconductor device of improved quality and reliability as relates to the connections between a semiconductor chip and the supporting frame pins.

A related manufacturing method allows the drawbacks and limitations of the prior art to be overcome.

### Summary of the Invention

In accordance with the invention, this and other objects are achieved by the provision of a semiconductor device having improved quality and reliability features, which comprises at least one semiconductor chip soldered to a metal supporting frame provided with contact pins, and wire leads connecting said pins to selected pads on the chip, and is characterized in that it comprises an unbroken connecting wire and two serially arranged bondings of said wire on each pin.

The features of the related manufacturing method are defined in the claims appended to the present specification.

The invention can be more clearly understood by making reference to the following description of an exemplary, and hence non-limitative, embodiment thereof, to be read in conjunction with the accompanying drawings.

### Brief Description of the Drawings

- Figure 1 is a schematic view of a semiconductor chip being mounted on a metal supporting frame and connected by wire leads in a conventional manner; and
- Figure 2 is a schematic view of a semiconductor chip being mounted on a metal supporting frame and subjected to a bonding procedure according to the inventive method.

### Detailed Description

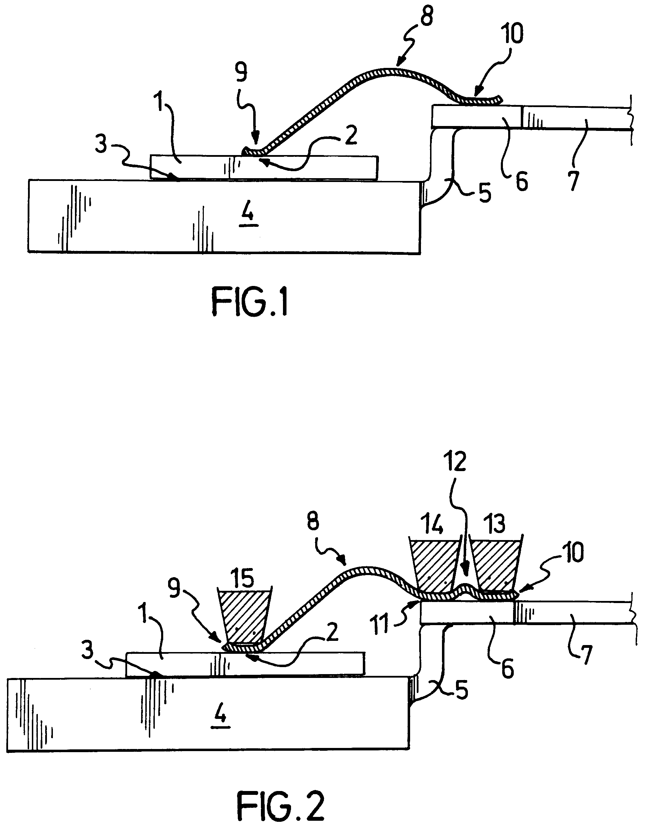

With reference to Figure 1, the prior art semiconductor device will be discussed first.

Shown at 1 is a chip of a semiconductor material such as silicon, whereon an electronic device has been realized.

The chip 1 is secured, using a solder 3, to the central area of a metal plate 4. The combination of the plate 4, the metal link 5, and the pin 7 constitutes the metal frame of the device.

Understandably, the metal frame would include several such pins 7 for use to plug the finished semiconductor device on a pre-printed electronic board.

Bonded between such pins 7 and a corresponding contact pads on the chip 1 is a wire lead 8. Specifically, said wire 8 is bonded to the inward end or post lead 6 of the pin 7 and the pad 2 of the chip 1.

Briefly, there are two bondings of the connecting wire 8: a first bonding 9 performed on the pad 2 of the chip 1, and a second 10 performed on the pin 7.

Both said wire bondings are performed on conventional equipment, e.g. ultrasound equipment, not shown.

With reference to Figure 2, the semiconductor device of this invention will be described.

Here again, the semiconductor device chip 1 carries the numeral 1, and the pad to be bonded a connecting wire lead 8 carries the numeral 2.

The chip is secured, using a solder 3, to the central area of a metal plate 4 which is joined by the link 5 to the pin 7 on the metal supporting frame.

Connected by bonding between each of said pins 7 and a corresponding pad 2 on the semiconductor chip is a connecting wire lead 8.

In accordance with the invention, the connecting wire 8 is at least twice bonded to the post lead 6 of each pin 7. The tandem bondings are indicated at 10 and 11, and are separated from each other on the post lead 6 by a distance which is at least twice the diameter dimension of the connecting wire, to avoid damage to the second bonding from the first.

Thus, the wire 8 will be hogged into a suitable bend 12 between the two bonding points.

Ultimately, the inventive device will exhibit two bondings of the connecting wire to the pin.

Such double bonding is highly advantageous in that it overcomes the limitations and drawbacks of prior techniques, to significantly enhance the quality and reliability of the device.

In fact, in an ideal situation, the likelihood of failure of the semiconductor device according to the invention would be the product of the probabilities that each of the pin connections fails independently.

For instance, where the defectiveness of a device with a single joint to the pin is of 1000 ppm, that of a device with two joints would be of 1 ppm.

While this only holds for an ideal situation, since the two bondings to the pin will not always be truly perfect, still it can be appreciated that the quality and reliability features of this device are greatly emhanced by the invention.

In particular, this enhanced reliability is specially important to power devices with wires up to 20 mil thick, devices employing connecting wires of aluminum, and devices wherein the surfaces of the pin post leads 6 generally afford less than ideal conditions for good wire bonding.

The manufacturing method of this invention will now be described with reference to Figure 2.

As previously mentioned, three bondings per connecting wire are required; the first two bondings 10, 11 being performed at the post lead 6 of the pin 7, and the third 9 at the pad 2 of the chip 1.

An ultrasound equipment of the stitch wire bonding type, well known to the skilled ones, is provided for this purpose and only partially shown in the drawing figure.

This equipment is provided on its end portion with an ultrasound bonding head which is driven automatically toward and away from the silicon chip 1, as well as to and from the pins 7.

In particular, the machine head has a tip formed with a suitable groove wherein the connecting wire is run and intended to abut the bonding area 13 or 14 or 15.

The tip is first brought to position 13 with the connecting wire 8 held beneath. The wire bonding 10 is then performed with the aid of ultrasound.

Thereafter, the tip is moved to position 14, at a distance from 13 which is at least twice the wire diameter dimension, while the wire becomes bent or curved as at 12. The wire 8 is presently held a second time to the pin, where its end portion 6 is again connected by a second bonding 11. The bonding equipment is then operated automatically to shift its tip to position 15, at the target pad 2 on the silicon chip 1 whereto the other end of the wire 8 is to be connected by a bonding 9.

On completion of this step of the bonding procedure, the tip is moved down and stopped at the position of the third bonding 9 to allow of the wire 8 to be parted using shears or another means.

Alternatively, the wire may be broken off by a sharp pull, where thin wires are used.

Finally, the tip is moved to another pin 7 of the frame to repeat the same bonding cycle as described above.

In accordance with the invention, the wire bonding to each pin is doubled because it has been found experimentally that wire bonding on the pins is more critical, and this ensures optimum quality and reliability features for a semiconductor device.

While a single embodiment of this invention has been described and illustrated, it is understood that many changes and modifications may be made thereunto without departing from the invention scope. For example, the semiconductor device may be other than a power transistor; it may be a highly complex integrated circuit, packaged under a plastics with the pins led out of one or more sides of the package.

Furthermore, the device might contain a number of semiconductor chips on its inside. Also, the manufacturing method is not limited to the use of ultrasound, but any equivalent technique may be used, such as a thermosonic one. The bonding sequence through the successive tip positions 13, 14 and 15 as described above could be reversed. (Notice that the tip shown in dash lines in Figure 2 would not locate simultaneously at 13, 14, 15.) In such a case, the first bonding 9 would be carried out with the tip at position 15, and the second and third bondings 11 and 10 to the pin would be carried out with the tip at positions 14 and 13, respectively.

## Claims

1. A semiconductor device having improved quality and reliability features and comprising at least one semiconductor chip (1) soldered to a metal supporting frame provided with connection pins (7), and wire leads (8) connecting said pins to selected points (6) on the chip, characterized in that it comprises an unbroken connecting wire (8) and two serially arranged bondings (10,11) of said wire on each pin (7).

2. A device according to Claim 1, characterized in that both bondings (10 and 11) of the wire (8) on each pin (7) are located on the post lead portion (6) thereof confronting the chip edge.

3. A device according to Claim 1, characterized in that the spacing between centers of the two bondings (10,11) on the pin (7) side is at least twice the diameter dimension of the connecting wire.

4. A device according to Claim 3, characterized in that the connecting wire (8) forms a bend (12) between the two bondings (10,11) on each pin (7).

5. A method for bonding wire leads (8) between a semiconductor chip (1) and corresponding pins (7) of a semiconductor device, having improved quality and reliability features, characterized in that it comprises the following steps:
- bringing the connecting wire (8), held in a groove of a bonding tip (13), on a post lead end (6) of a pin (7);
- performing a first bonding (10) of said connecting wire on said pin;
- shifting the bonding tip (14) with the wire (8) beneath to a second peripheral portion (6) of the pin (7) and performing a second bonding (11) close to the first (10) one;
- setting the bonding tip (15), with the same connecting wire (8) beneath, on the semiconductor chip (1) and performing a corresponding third bonding (9); and
- while holding the tip (15) firmly against the third bonding (9), parting the connecting wire.

6. A method according to Claim 5, characterized in that the amount of displacement of the tip over the pin is at least twice the diameter dimension of the wire (8) and such that a bend (12) is formed in the connecting wire (8) between said bonding positions (10,11).

7. A manufacturing method according to Claim 5, characterized in that the sequence of three bondings is reversed to first perform the bonding on the chip (1) and end by performing the third bonding on the pin (7).

8. A manufacturing method according to either Claim 5 or 7, characterized in that the connecting wire (8) is unbroken and is curved between each bonding pair.

9. A manufacturing method according to either Claim 5 or 7, characterized in that the wire (8) bondings (10,11) to each pin (7) are restricted to the terminating portion (6) thereof confronting the chip edge.

10. A manufacturing method according to Claim 9, characterized in that the spacing of the two bondings (10,11) on each pin (7) is at least twice the diameter dimension of the connecting wire (8).

11. A manufacturing method according to either Claim 5 or 7, characterized in that all the connecting wire bondings (9,10,11) are performed using stitch wire bonding techniques and have substantially equal areas.
